# EUROPEAN PATENT SPECIFICATION

(11) **EP 0 537 001 B1**
(45) Date of publication and mention of the grant of the patent: **02.07.1997**
(21) Application number: 92309176.3
(22) Date of filing: 08.10.1992
(51) Int. Cl.: H01L 21/768, H01L 21/316

(54) **Forming dielectrics in semiconductor devices**
Herstellung von Dielektrika in Halbleitervorrichtungen
Formation de diélectriques dans des dispositifs semi-conducteurs

(30) Priority: 10.10.1991 KR 1774091
(43) Date of publication of application: 14.04.1993
(73) Proprietor: SAMSUNG ELECTRONICS CO. LTD., Suwon-city, Kyounggi-do (KR)
(72) Inventor: Kim, Chang-Gyu, Suwon, Kyungki-do (KR); Choi,Ji-Hyun Process Development Team 2, Kiheung-eup,Yongin-kun,Kyungki-do (KR)
(74) Representative: Stanley, David William

(56) References cited:
- EP-A- 0 065 448
- EP-A- 0 349 070
- EP-A- 0 411 795

## Description

The present invention relates to the fabrication of semiconductor devices, and more particularly to forming inter-metal dielectrics in semiconductor devices.

Recently, highly integrated semiconductor devices tend to have multiple conductive layers, which intensifies the importance of flatness of insulating layers between metal layers. In order to achieve the flatness of the insulating layers between the multiple metal layers in a semiconductor device, there is generally used a spin-on glass process, an etch-back process, or a resinous insulating process using polyimide. However, these give rise to problems such as voids, cracks, etc. produced in regions between conductive lines during the planarization process, because the conductive lines have increased step differences and the intervals between the conductive lines are of the order of submicrons.

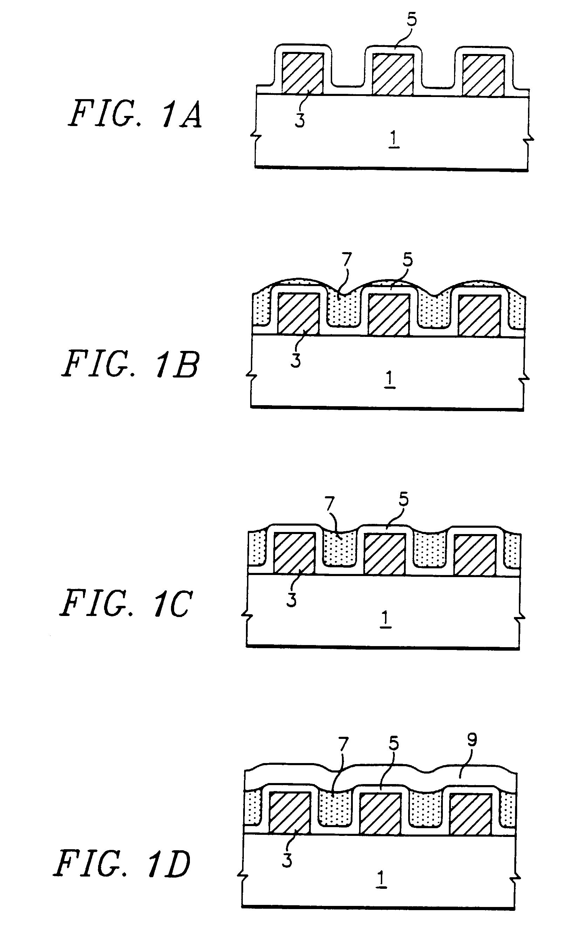

There is shown a conventional spin-on glass planarization process in Figures 1A-1D of the accompanying diagrammatic drawings. In this case, the starting material is a semiconductor substrate with lower conductive lines 3. The process for forming transistors, capacitors, etc. is neglected in the drawings. Referring to Figure 1A, a second insulating layer 5 of oxide is deposited over a semiconductor substrate (not shown) with a first insulating layer 1 of BPSG (Boro-Phospho-Silicate Glass) and a first metal layer 3 forming the lower conductive lines. In the step of Figure 1B, a third insulating layer 7 of spin-on glass is applied and subjected to heat treatment. The third insulating layer is usually coated several times to improve step coverage and avoid cracks. In the step of Figure 1C, the spin-on glass layer 7 is etched-back so as to expose the portions of the insulating layer 5 over the first metal layer 3. In the step of Figure 1D, a fourth insulating layer 9 for buffering is finally laid over the substrate completing the planarization of the insulating layer between the lower and upper conductive lines. However, the spin-on glass layer 7 is so weak as to be easily cracked, so that reliability of the semiconductor device can not be assured.

EP-A-349070 discloses the steps of sequentially forming first and second insulating layers over a semiconductor substrate having a patterned metal layer, such that portions of the first and second insulating layers are selectively exposed and depositing a third insulating layer over the first and second insulating layers. The surfaces of the second insulating layer are anisotropically etched once deposited to provide a V-shaped groove with gently sloping surfaces 37 between the metallisations. Because the grooves are V-shaped, the subsequently formed insulating layer may be isotropically deposited on the gently sloping surfaces and becasue there are no enclosed angles of greater than 90 degrees on or adjacent the gently sloping surfaces the third insulating layer can be isotropically deposited without forming voids.

EP-A-0 411 795 discloses the anisotropic deposition of SiO₂ with different deposition rates on vertical layers than on horizontal ones.

Preferred embodiments of the present invention aim to provide an improved method for forming inter-metal dielectrics without voids in a semiconductor device.

Another aim is to provide a method for forming inter-metal dielectrics in a semiconductor device, which inter-metal dielectrics have a good resistance against cracking and a good planarization.

According to the present invention, there is provided a method of forming an inter-metal dielectric in a semiconductor device, comprising the steps of:
sequentially forming first and second insulating layers over a semiconductor substrate having a patterned metal layer, such that portions of said first insulating layer and portions of said second insulating layer are selectively exposed; and
depositing a third insulating layer on said exposed portions of said first and second insulating layers, characterised in that the deposition rate of said third insulating layer is different on said exposed portions of said first insulating layer to the rate on said exposed portions of said second insulating layer because the deposition rate of the third layer is a function of the material onto which it is being deposited.

Preferably, said exposed portions of said first insulating layer are over respective portions of said patterned metal layer.

Preferably, said exposed portions of said first insulating layer are exposed by etching-back said second insulating layer so as to form spacers of said second insulating layer over side walls of said first insulating layer.

Preferably, said exposed portions of said first insulating layer are exposed by:
applying a sacrificial layer to said second insulating layer;
etching-back said sacrificial layer so as to expose said second insulating layer on said patterned metal layer and first insulating layer, thereby leaving sacrificial layer portions between portions of said patterned metal layer; and
removing the exposed portions of said second insulating layer by using said remaining sacrificial layer portions as a mask.

Preferably, said sacrificial layer comprises a photoresist or spin-on glass layer.

A method as above may include the preliminary step of forming said patterned metal layer on said substrate.

Preferably, said first insulating layer comprises phospho-silicate glass (PSG), O₃-tetra- ethyl-ortho-silicate phospho silicate glass (O₃-TEOS PSG), O₃-tetra-ethyl-ortho-silicate boro-phospho-silicate glass (O₃-TEOS BPSG), P-TEOS undoped silicate glass (USG) or TiN.

Preferably, said second insulating layer comprises plasma-enhancement silane USG (P-SiH₄ USG) or O₃-TEOS USG.

Preferably, said third insulating layer comprises O₃-TEOS USG.

For a better understanding of the invention, and to show how the same may be carried into effect, reference will now be made, by way of example, to Figures 2 to 4 of the accompanying diagrammatic drawings, in which:
Figures 2A to 2C are cross-sectional views for schematically illustrating one example of a method of forming inter-metal dielectrics according to an embodiment of the present invention;
Figures 3A to 3D are cross-sectional views for schematically illustrating another example of a method of forming inter-metal dielectrics according to the present invention; and
Figures 4A to 4D are cross-sectional views for schematically illustrating a further example of a method of forming inter-metal dielectrics according to a further embodiment of the present invention.

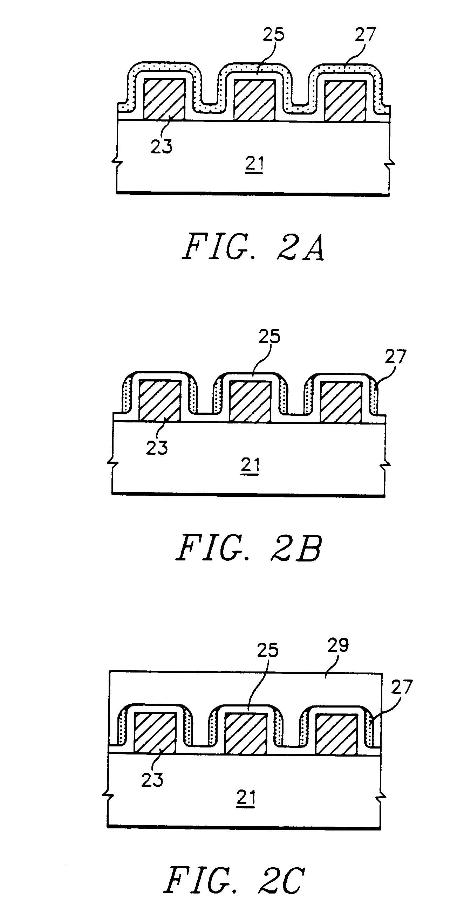

Referring to Figures 2A-2C, a first insulating layer 25 of about 1000Å thickness and a second insulating layer 27 of about 1000Å are sequentially formed over a semiconductor substrate (not shown) with an inter-metal dielectric 21 formed of BPSG and a first metal layer 23 forming lower conductive lines, in the step of Figure 2A. The first insulating layer 25 consists of PSG (Phospho-Silicate Glass), O₃-TEOS PSG (O₃-Tetra-Ethyl-Ortho-Silicate Phospho-Silicate-Glass), O₃-TEOS BPSG, or P-TEOS USG (Plasma-enhanced Tetra Ethyl Ortho Silicate Undoped Silicate Glass), and the second insulating layer 27 consists of P-SiH₄ USG (Plasma-enhanced Silane Undoped Silicate Glass) or O₃-TEOS USG. In the step of Figure 2B, the second insulating layer 27 is etched-back so as to form spacers 27 of the second insulating layer over the side walls of the first insulating layer 25. In the step of Figure 2C, a third insulating layer 29 whose deposition rate depends on the lower layer is laid to about 6000Å thickness over the substrate. The third insulating layer 29 is an oxide layer such as O₃-TEOS USG whose deposition rate depends on the lower layer and thus is higher in the region over the second insulating spacer 27 than in the region over the first insulating layer 25. As a result there is obtained a flat insulating layer without voids even if the intervals between the conductive lines are narrow and the step differences are greatly increased.

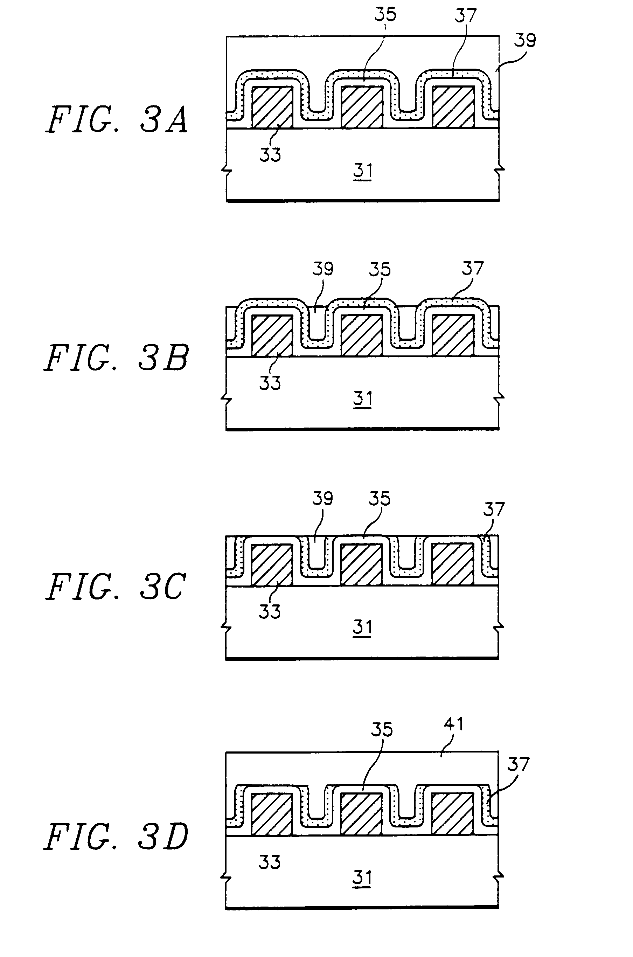

Referring to Figures 3A-3D, over a semiconductor substrate (not shown) with an inter-metal dielectric 31 and first metal layer 33 forming lower conductive lines there are sequentially formed first insulating layer 35 of about 1000Å thickness, a second insulating layer 37 consists of about 1000Å thickness and photoresist 39, in the step of Figure 3A. The first insulating layer 35 consists of PSG, O₃-TEOS PSG, O₃-TEOS BPSG, or P-TEOS USG, and the second insulating layer 37 consists of P-SiH₄ USG or O₃-TEOS USG. In the step of Figure 3B, the photoresist 39 is etched-back so as to expose the second insulating layer 37 thereby leaving photoresist portions in the recesses between the first metal layers 33. In the step of Figure 3C, the exposed portions of the second insulating layer 37 are removed by using the remaining photoresist portions as a mask. Then a third insulating layer 41 of O₃-TEOS USG is formed over the substrate after removing the photoresist 39, in the step of Figure 3D. The deposition rate of the third insulating layer 41 depends on the property of the lower insulating layer. Namely, the deposition rate of the third insulating layer 41 is greater in the region over the second insulating layer 37 than in the region over the first insulating layer 35. As a result the portions of the third insulating layer between the metal layers 33 have a thickness great enough to compensate for the depth of the recesses between the metal layers, thus preferably planarizing the inter-metal dielectric. In this embodiment, a photoresist mask is employed to cause portions of the second insulating layer 37 to remain only in predetermined regions, but a spin-on glass layer may be employed in other embodiments.

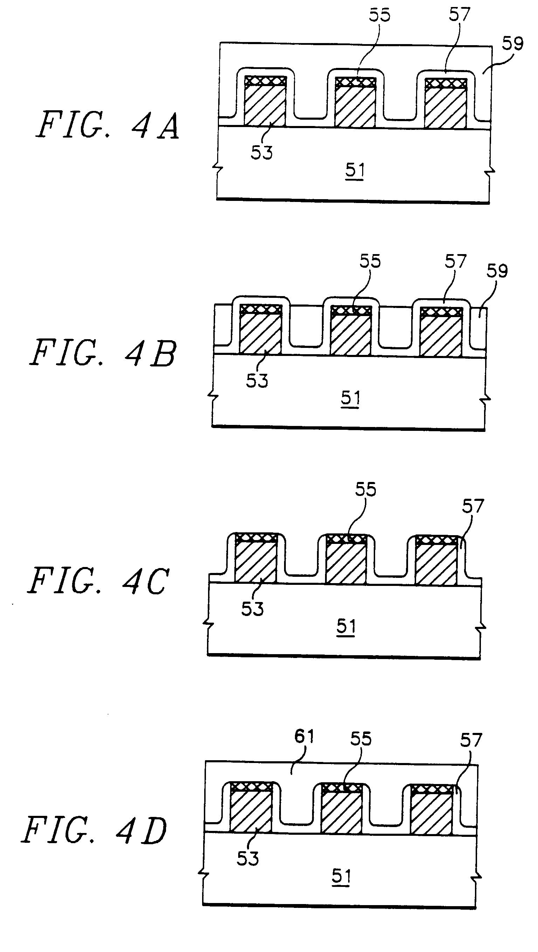

Referring to Figures 4A-4D, a metal layer 53 forming lower conductive lines and a first insulating layer 55 are sequentially deposited over a semiconductor substrate (not shown) with an inter-metal dielectric 51, in the step of Figure 4A. In this case the thickness of the first insulating layer 55 is about 1000Å. A second insulating layer 57 of about 1000Å thickness is formed over the substrate. The first insulating layer 55 consists of PSG, TiN or P-TEOS USG, and the second insulating layer 57 P-SiH₄ USG or O₃-TEOS USG. A sacrificial layer 59 formed of photoresist or spin-on glass is applied to the second insulating layer 57. The sacrificial layer is etched-back so as to expose the second insulating layer 57 on the patterned metal layers 53 and first insulating layers 55 with sacrificial layer portions 59 remaining in the recesses between the patterned metal layers 53 in the step of Figure 4B. The exposed portions of the second insulating layer 57 are removed by using the remaining sacrificial layer portions as a mask in the step of Figure 4C. A third insulating layer 61 such as O₃-TEOS USG whose deposition rate depends on the property of the lower layer 53 is formed over the first and second insulating layers 55, 57 after removing the remaining sacrificial layer portions 59. Namely, the deposition rate of the third insulating layer is greater in the region over the second insulating layer 57 than in the region over the first insulating layer 55. As a result, the portions of the third insulating layer 61 between the metal layers have a thickness great enough to compensate for the depth of the recesses between the metal layers, thus preferably planarizing the inter-metal dielectric.

Thus, in the illustrated examples of the present invention, different insulating layers are exposed over different regions of a semiconductor substrate and an insulating layer whose deposition rate depends on the exposed lower layer is deposited, so that it is possible to control the thickness of the inter-metal dielectrics according to the different regions. Hence there are obtained inter-metal dielectrics without voids and a good planarization, which increases the reliability of the semiconductor devices.

## Claims

1. A method of forming an inter-metal dielectric in a semiconductor device, comprising the steps of:
sequentially forming first and second insulating layers over a semiconductor substrate having a patterned metal layer, such that portions of said first insulating layer and portions of said second insulating layer are selectively exposed; and
depositing a third insulating layer on said exposed portions of said first and second insulating layers, characterised in that the deposition rate of said third insulating layer is different on said exposed portions of said first insulating layer to the rate on said exposed portions of said second insulating layer because the deposition rate of the third layer is a function of the material onto which it is being deposited.

2. A method according to claim 1, wherein said exposed portions of said first insulating layer are over respective portions of said patterned metal layer.

3. A method according to claim 1 or 2, wherein said exposed portions of said first insulating layer are exposed by etching-back said second insulating layer so as to form spacers of said second insulating layer over side walls of said first insulating layer.

4. A method according to any of the preceding claims, wherein said exposed portions of said first insulating layer are exposed by:
applying a sacrificial layer to said second insulating layer;
etching-back said sacrificial layer so as to expose said second insulating layer on said patterned metal layer and first insulating layer, thereby leaving sacrificial layer portions between portions of said patterned metal layer; and
removing the exposed portions of said second insulating layer by using said remaining sacrificial layer portions as a mask.

5. A method according to claim 4, wherein said sacrificial layer comprises a photoresist or spin-on glass layer.

6. A method according to any of the preceding claims, including the preliminary step of forming said patterned metal layer on said substrate.

7. A method according to any of the preceding claims, wherein said first insulating layer comprises phospho-silicate glass (PSG), O₃-tetra- ethyl-ortho-silicate phospho silicate glass (O₃-TEOS PSG), O₃-tetra-ethyl-orthosilicate boro-phospho-silicate glass (O₃-TEOS BPSG), P-TEOS undoped silicate glass (USG) or TiN.

8. A method according to any of the preceding claims, wherein said second insulating layer comprises plasma-enhancement silane USG (P-SiH₄ USG) or O₃-TEOS USG.

9. A method according to any of the preceding claims, wherein said third insulating layer comprises O₃-TEOS USG.

## Patentansprüche

1. Verfahren zur Bildung eines zwischen Metall und Metall angeordneten Dielektrikums in einer Halbleitervorrichtung, das die folgenden Schritte beinhaltet:
die aufeinanderfolgende Bildung erster und zweiter Isolierschichten über einem Halbleitersubstrat mit einer strukturierten Metallschicht, so daß Teile der ersten Isolierschicht und Teile der zweiten Isolierschicht selektiv freigelegt werden; sowie
die Abscheidung einer dritten Isolierschicht auf die freigelegten Teile der ersten und zweiten Isolierschichten, dadurch gekennzeichnet, daß die Abscheiderate der dritten Isolierschicht auf den freigelegten Teilen der ersten Isolierschicht sich von der Rate auf den freigelegten Teilen der zweiten Isolierschicht unterscheidet, da die Abscheiderate der dritten Schicht von dem Material abhängt, auf das sie abgeschieden wird.

2. Verfahren nach Anspruch 1, bei dem die freigelegten Teile der ersten Isolierschicht sich über entsprechenden Teilen der strukturierten Metallschicht befinden.

3. Verfahren nach Anspruch 1 oder 2, bei dem die freigelegten Teile der ersten Isolierschicht durch Rückätzen der zweiten Isolierschicht freigelegt werden, so daß Abstandshalter aus der zweiten Isolierschicht über Flanken der ersten Isolierschicht gebildet werden.

4. Verfahren nach den vorhergehenden Ansprüchen, bei dem die freigelegten Teile der ersten Isolierschicht freigelegt werden, indem:
eine Opferschicht auf die zweite Isolierschicht aufgebracht wird;
die Opferschicht rückgeätzt wird, um die zweite Isolierschicht auf der strukturierten Metallschicht und ersten Isolierschicht freizulegen und dadurch Opferschichtteile zwischen Teilen der strukturierten Metallschicht zurückzulassen; sowie
die freigelegten Teile der zweiten Isolierschicht durch Verwendung der verbliebenen Opferschichtteile als Maske entfernt werden.

5. Verfahren nach Anspruch 4, bei dem die Opferschicht aus einem Photolack oder einer aufgeschleuderten Glasschicht besteht.

6. Verfahren nach den vorhergehenden Ansprüchen einschließlich des einleitenden Schritts der Bildung der strukturierten Metallschicht auf dem Substrat.

7. Verfahren nach den vorhergehenden Ansprüchen, bei dem die erste Isolierschicht aus Phosphosilicatglas (PSG), O₃-Tetraethylorthosilicat-Phosphosilicatglas (O₃-TEOS-PSG ),O₃-Tetraethylorthosilicat-Borophosphosilicatglas (O₃-TEOS-BPSG), nichtdotiertem P-TEOS-Silicatglas (NSG) oder TiN besteht.

8. Verfahren nach den vorhergehenden Ansprüchen, bei dem die zweite Isolierschicht aus Plasmaunterstützungs-Silan-NSG (P-SiH₄-NSG) oder O₃-TEOS-NSG besteht.

9. Verfahren nach den vorhergehenden Ansprüchen, bei dem die dritte Isolierschicht aus O₃-TEOS-NSG besteht.

## Revendications

1. Procédé de formation d'un diélectrique intermétallique dans un dispositif à semi-conducteurs, comprenant les étapes consistant à:
former successivement une première couche isolante et une deuxième couche isolante sur un substrat semiconducteur portant une couche métallique à dessins, de telle sorte que des parties de la première couche isolante et de la deuxième couche isolante soient exposées sélectivement; et
déposer une troisième couche isolante sur les parties exposées de ladite première couche isolante et de ladite deuxième couche isolante, caractérisé en ce que la vitesse de dépôt de ladite troisième couche isolante est différente sur lesdites parties exposées de ladite première couche isolante de la vitesse sur lesdites parties exposées de ladite deuxième couche isolante parce que la vitesse de dépôt de la troisième couche est fonction du matériau sur lequel elle est déposée.

2. Procédé selon la revendication 1, dans lequel lesdites parties exposées de ladite première couche isolante recouvrent les parties respectives de ladite couche métallique à dessins.

3. Procédé selon la revendication 1 ou 2, dans lequel lesdites parties exposées de ladite première couche isolante sont exposées par gravure en retrait de ladite deuxième couche isolante de manière à former des écarteurs de ladite deuxième couche isolante sur les parois latérales de ladite première couche isolante.

4. Procédé selon l'une quelconque des revendications précédentes, dans lequel lesdites parties exposées de ladite première couche isolante sont exposées par:
application d'une couche sacrificielle sur ladite deuxième couche isolante;
gravure en retrait de ladite couche sacrificielle de manière à exposer ladite deuxième couche isolante sur ladite couche métallique à dessins et la première couche isolante, pour laisser des parties de la couche sacrificielle entre les parties de ladite couche métallique à dessins; et
éliminer les parties exposées de ladite deuxième couche isolante en utilisant comme masque lesdites parties de couche sacrificielle restantes.

5. Procédé selon la revendication 4, dans lequel ladite couche sacrificielle comprend un photorésist ou une couche de verre centrifugé.

6. Procédé selon l'une quelconque des revendications précédentes, comprenant l'étape préliminaire consistant à former ladite couche métallique à dessins sur ledit substrat.

7. Procédé selon l'une quelconque des revendications précédentes, dans lequel ladite première couche isolante comprend du verre de phosphosilicate (PSG), du verre de 03-tétraéthyl-ortho-silicate phosphosilicate (O₃-TEOS PSG), du verre de O₃-tétraéthyl-ortho-silicate borophosphosilicate (O₃-TEOS BPSG), du verre de silicate non dopé au P-TEOS (USG) ou TiN.

8. Procédé selon l'une quelconque des revendications précédentes, dans lequel ladite deuxième couche isolante comprend un USG au silane amélioré par plasma (P-SiH₄ USG) ou un O₃-TEOS USG.

9. Procédé selon l'une quelconque des revendications précédentes, dans lequel ladite troisième couche isolante comprend un O₃-TEOS USG.
